# EUROPÄISCHE PATENTANMELDUNG

(11) **EP 3 367 426 A1**
(43) Veröffentlichungstag der Anmeldung: **29.08.2018**
(21) Anmeldenummer: 17158155.6
(22) Anmeldetag: 27.02.2017
(51) Int. Cl.: H01L 21/48

(54) **HALBLEITERMODUL MIT KÜHLKÖRPER**

(71) Anmelder: Siemens Aktiengesellschaft, 80333 München (DE)
(72) Erfinder: Seibicke, Frank, 14822 Borkheide (DE)

(57) **Zusammenfassung**

Die Erfindung betrifft ein Verfahren zur Herstellung eines Halbleitermoduls (1) mit einem Kühlkörper (2). Zur Verbesserung des Wärmeübergangs zwischen Halbleitermodul (1) und Kühlkörper (2) wird vorgeschlagen, dass der Kühlkörper (2) mittels eines additiven Fertigungsverfahrens auf eine Bodenplatte (11) des Halbleitermoduls (1) aufgetragen wird, wobei der Kühlkörper (2) durch Auftragen eines Materials gebildet wird, das Metall aufweist. Weiter betrifft die Erfindung ein Halbleitermodul (1) mit einem Kühlkörper (2), wobei der Kühlkörper (2) mittels eines solchen Verfahrens an der Bodenplatte (11) des Halbleitermoduls (1) angeordnet ist.

## Beschreibung

Die Erfindung betrifft ein Verfahren zur Herstellung eines Halbleitermoduls mit einem Kühlkörper. Ferner betrifft die Erfindung ein Halbleitermodul mit einem Kühlkörper.

Halbleiter und insbesondere Leistungshalbleiter sind verlustbehaftete Bauelemente. Zur Aufrechterhaltung ihrer Funktion und Gewährleistung ihrer Lebensdauer benötigen sie eine ausreichende Kühlung. Die Halbleiter werden üblicherweise mit einer kraft- und formschlüssigen Verbindung mit Kühlkörpern in Verbindung gebracht, um die zulässigen Betriebstemperaturen zu gewährleisten. Dabei kommen in vielen Fällen zur Verbesserung des Wärmeübergangs zusätzliche Wärmeleitpasten zur Überbrückung des Kontaktspalts zum Einsatz.

Mit einem additiven Fertigungsverfahren bezeichnet man ein Verfahren, bei dem, insbesondere auf der Basis von Projektierungsdaten, durch das Ablagern und Aufbringen von Material schichtweise ein Bauteil oder eine Komponente aufgebaut wird. Für dieses Verfahren ist auch der Begriff "3D-Druck" geläufig. Das additive Fertigungsverfahren unterscheidet sich von herkömmlichen Produktionsverfahren, bei dem abtragende Fertigungsmethoden zum Einsatz kommen, dadurch, das Material aufgebracht wird, um ein Bauteil zu erzeugen. Um das Material aufzubringen, kommen beispielsweise Pulver im Bettverfahren oder Flüssigmaterialverfahren zum Einsatz. Daneben sind auch Freiraumverfahren bekannt. Das Pulver wird aufgebracht und durch Erhitzung, beispielsweise mittels eines Lasers in eine feste Form gebracht. Mit diesen Verfahren ist es möglich, aus einem teilweise sogar sehr feinen Pulver Schicht für Schicht ein Bauteil aufzubauen. Dabei können die Materialien Metalle, Keramiken, Kunststoffe oder Verbundwerkstoffe aufweisen. Ebenso ist eine Kombination dieser Stoffe möglich.

Unter einem 3D-Drucker versteht man eine Vorrichtung, die eine additive Fertigung ermöglicht.

Der Erfindung liegt die Aufgabe zugrunde, die Verbindung zwischen einem Halbleitermodul und einem Kühlkörper zu verbessern.

Diese Aufgabe wird durch ein Verfahren zur Herstellung eines Halbleitermoduls mit einem Kühlkörper gelöst, wobei der Kühlkörper mittels eines additiven Fertigungsverfahrens auf eine Bodenplatte des Halbleitermoduls aufgetragen wird, wobei der Kühlkörper durch Auftragen eines Materials gebildet wird, das Metall und/oder einen Keramikanteil aufweist.

Ferner wird die Aufgabe durch ein Halbleitermodul mit einem Kühlkörper gelöst, wobei der Kühlkörper mittels eines solchen Verfahrens an der Bodenplatte des Halbleitermoduls angeordnet ist.

Weitere vorteilhafte Ausgestaltungen der Erfindung sind in den abhängigen Ansprüchen angegeben.

Der Erfindung liegt die Erkenntnis zugrunde, dass sich die Verbindung und damit der Wärmeübergang zwischen einem Halbleitermodul als Wärmequelle und einem Kühlkörper als Wärmesenke dadurch verbessern lässt, dass die kraft- und formschlüssige Verbindung ersetzt wird. Anstelle dieser kraft- und formschlüssigen Verbindung wird der Kühlkörper mittels eines additiven Fertigungsverfahrens direkt auf die Bodenplatte des Halbleitermoduls aufgetragen. Damit kann ein guter Wärmeübergang zwischen Halbleitermodul und Kühlkörper sichergestellt werden. Dies ist insbesondere dann der Fall, wenn der Kühlkörper mittels eines Materials gebildet wird, das Metall, Metallkomponenten und/oder einen Keramikanteil aufweist, da das Metall bzw. die Keramik eine hohe Wärmeleitfähigkeit aufweist. Als besonders vorteilhaft hat es sich erwiesen, ein Material, wie beispielsweise Metall, eine Metalllegierung oder eine Keramik, mit hoher Wärmeleitfähigkeit für den Aufbau des Kühlkörpers zu verwenden.

Durch die Herstellung mittels eines additiven Fertigungsverfahrens ist das Halbleitermodul stoffschlüssig mit der Kühlstruktur verbunden. Auf das Einbringen von Wärmeleitpaste, die oftmals nur eine beschränkte Lebensdauer hat und damit die Lebensdauer des gesamten Halbleitermoduls herabsetzt, kann verzichtet werden.

Bei einer vorteilhaften Ausgestaltung der Erfindung wird der Kühlkörper mittels eines 3D-Druckers auf die Bodenplatte aufgetragen. Mit Hilfe eines 3D-Druckers ist es einfach und kostengünstig möglich, das additive Fertigungsverfahren auszuführen. 3D-Drucker stehen heutzutage schon in hinreichend guter Qualität und vergleichsweise günstigen Preisen am Markt zur Verfügung. Mit Hilfe des 3D-Druckers ist es möglich, auf einfache Weise aus Konstruktionsdaten den Kühlkörper auf die Bodenplatte des Halbleiters aufzubringen.

Bei einer weiteren vorteilhaften Ausgestaltung der Erfindung wird beim Auftragen des Materials innerhalb des Kühlkörpers mindestens ein Hohlraum vorgesehen, der mit einem Fluid durchströmbar ist. Mit diesem Hohlraum ist es möglich, die entstehende Wärme im Halbleitermodul zur Kühlung an ein Fluid, insbesondere an Wasser, zu übertragen. Dabei ist es vorteilhaft, wenn sich der Hohlraum über weite Teile des Inneren des Kühlkörpers erstreckt. Am Rand, d.h. an einer Außenfläche des Kühlkörpers sind dann jeweils zwei Zugänge zu den Hohlräumen vorhanden. Der Hohlraum erstreckt sich dann von dem ersten dieser Zugänge durch das Innere des Kühlkörpers zu dem zweiten Zugang. Die Zugänge bilden dann jeweils mindestens einen Kühlmittelzulauf und mindestens einen Kühlmittelablauf für den Kühlkörper. Um eine besonders gleichmäßige Entwärmung des Kühlkörpers sicherzustellen, hat es sich als vorteilhaft erwiesen, wenn sich der Hohlraum mäanderförmig durch den gesamten Kühlkörper erstreckt. Der Querschnitt des Hohlraums kann dabei kreisförmig, oval, rechteckig usw. ausgeführt sein. An Punkten mit besonders hohem Wärmeeintrag kann eine Art Netz sich über den Querschnitt des Hohlraums erstrecken um den Wärmeübergang vom Kühlkörper zum Fluid zu verbessern.

Bei einer weiteren vorteilhaften Ausgestaltung der Erfindung wird das aufgetragene Material in Form von Kühlrippen aufgetragen. Damit eignet sich der Kühlkörper insbesondere für die Kühlung mit einem Gas, insbesondere mit Luft. Als besonders vorteilhaft hat es sich erwiesen, wenn die Kühlrippen kühlungsgeeignete Strukturen aufweisen. Damit ist gemeint, dass die Oberfläche, an der das zu kühlende Gas, insbesondere die Luft, vorbeiströmt, eine hohe wirksame Oberfläche aufweist. Diese stellt einen besonders guten Wärmeübergang vom Kühlkörper zur Kühlluft sicher. Es ist darüber hinaus möglich, dass der Kühlkörper sowohl einen oder mehrere Hohlräume für eine Flüssigkeitskühlung als auch Kühlrippen für eine Luftkühlung aufweist. Damit ist eine besonders effektive Kühlung möglich.

Bei einer weiteren vorteilhaften Ausgestaltung der Erfindung wird zwischen zumindest zwei der Kühlrippen Material eingebracht, das die zumindest zwei der Kühlrippen durch einen Steg miteinander verbindet. Bei einem herkömmlichen Kühlkörper mit Kühlrippen ist es nicht oder nur mit erheblichen Aufwand möglich, die einzelnen Kühlrippen miteinander zu verbinden. Dies liegt darin begründet, dass die Kühlrippen einzeln und nacheinander in die Grundplatte des Kühlkörpers eingebracht werden. Durch das additive Fertigungsverfahren, bei dem die Kühlrippen gleichzeitig aufgetragen werden, ist es auf einfache Weise möglich, eine Verbindung zwischen den einzelnen Kühlrippen zu schaffen. Mit dieser Verbindung und dem damit einhergehenden Wärmeaustausch kann sich die entstehende Wärme gleichmäßig auf die einzelnen Kühlrippen verteilen. Damit erhöht sich die für die Kühlung wirksame Oberfläche des Kühlkörpers. Dadurch wird eine besonders effektive Kühlung erreicht. Dabei kann eine Teilmenge der Kühlrippen miteinander verbunden werden. Alternativ ist es auch möglich alle Kühlrippen jeweils paarweise miteinander zu verbinden. Als besonders vorteilhaft hat es sich erwiesen, Kühlrippen miteinander zu verbinden, die von Seiten des Halbleitermoduls einen unterschiedlichen Wärmeeintrag erfahren. Damit kann die Kühlung verbessert werden, indem die Kühlrippe mit dem höheren Wärmeintrag einen Teil dieses Wärmeeintrags auf mindestens eine weitere Kühlrippe verteilt. Dies erhöht die wirksame Oberfläche und verbessert die Kühlung.

Im Folgenden wird die Erfindung anhand der in den Figuren dargestellten Ausführungsbeispiele näher beschrieben und erläutert. Es zeigen:
- FIG 1: ein erstes Ausführungsbeispiel eines Halbleitermoduls mit einem Kühlkörper für Luftkühlung,
- FIG 2: ein weiteres Ausführungsbeispiel mit einem Kühlkörper für Flüssigkeits-/Wasserkühlung,
- FIG 3: ein weiteres Ausführungsbeispiel eines Halbleitermoduls mit einem Kühlkörper für eine kombinierte Wasser/Luftkühlung.

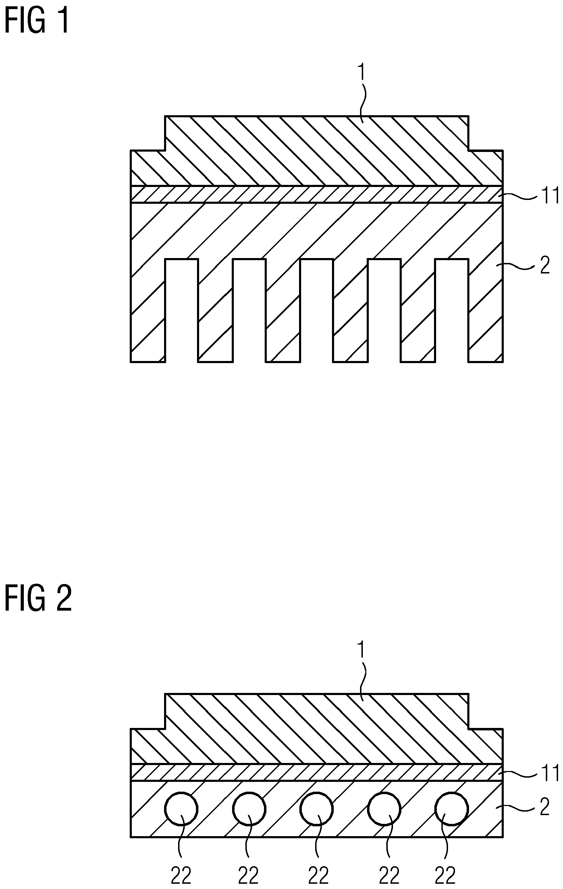

FIG 1 zeigt ein Halbleitermodul 1 mit einer Bodenplatte 11 an der ein Kühlkörper 2 angeordnet ist. Der Kühlkörper 2 ist mittels eines additiven Fertigungsverfahrens auf die Bodenplatte 11 aufgetragen. Daher sind für die Verbindung weder Schraubverbindungen noch Wärmeleitpaste erforderlich, um einen hinreichenden Wärmeübergang sicher zu stellen. Der Kühlkörper 2 dieses Ausführungsbeispiel eignet sich für die Kühlung mit einem Gas, insbesondere mit Luft. Die Luft streicht an den Kühlrippen entlang und entwärmt damit das Halbleitermodul 1.

FIG 2 zeigt ein weiteres Ausführungsbeispiel für ein Halbleitermodul 1 mit einem Kühlkörper 2. Der hier dargestellte Kühlkörper 2 eignet sich für die Kühlung mit einem Fluid. Zur Vermeidung von Wiederholungen wird auf die Beschreibung zur FIG 1 und die dort eingeführten Bezugszeichen verwiesen. Innerhalb des Kühlkörpers 2 weist dieser Kühlkörper 2 Hohlräume 22 auf. Diese können in vorteilhafter Weise so angeordnet werden, dass sie eine durchgängige Rohrverbindung innerhalb des Kühlkörpers 2 darstellen. Dabei sind mindestens zwei Öffnungen an die Außenseite des Kühlkörpers 2 hinausgeführt, die jeweils einen Ein- oder Ausgang für das Kühlmittel darstellen. Innerhalb des Kühlkörpers kann sich der Hohlraum mäanderförmig ausbreiten. Alternativ ist es auch möglich, mehrere Öffnungen der Hohlräume nach außen an die Oberfläche des Kühlkörpers 2 zu führen und dort mit einem Kühlkreislauf zu verbinden.

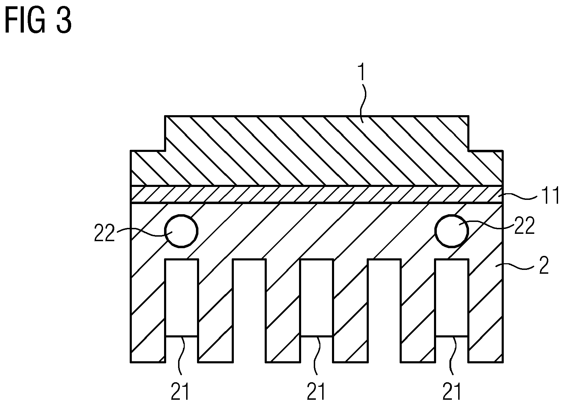

FIG 3 zeigt einen Kühlkörper 2 der für eine kombinierte Kühlung mit Flüssigkeit und Gas, insbesondere Luft, geeignet ist. Zur Vermeidung von Wiederholungen wird auf die Beschreibung zu den Figuren 1 und 2 sowie auf die dort eingeführten Bezugszeichen verwiesen. Bei diesem Ausführungsbeispiel weist der Kühlkörper zwei Öffnungen auf, an denen der Hohlraum 22 sich bis an die Oberfläche des Kühlkörpers erstreckt. Zwischen den Öffnungen erstreckt sich der Hohlraum durch das Innere des Kühlkörpers 2. Die Öffnungen bilden jeweils einen Eintritt und einen Austritt für das flüssige Kühlmedium. Um die Leistungsfähigkeit des Kühlkörpers 2 zu erhöhen, weist der Kühlkörper 2 darüber hinaus Kühlrippen auf, an denen der Kühlkörper Wärme an ein vorbeiströmendes Gas, insbesondere an Luft abgeben kann. Zur Erhöhung der Stabilität des Systems können zwischen einzelnen Kühlrippen Stege 21 angeordnet sein, die jeweils zwei Kühlrippen miteinander verbinden. Ebenso ist es möglich, zwischen allen der Kühlrippen jeweils paarweise Stege 21 vorzusehen. Damit erhält der Kühlkörper 2 eine besonders hohe Stabilität. Diese hohe Stabilität ist gerade bei langen und/oder schweren Kühlrippen besonders vorteilhaft.

Zusammenfassend betrifft die Erfindung ein Verfahren zur Herstellung eines Halbleitermoduls mit einem Kühlkörper. Zur Verbesserung des Wärmeübergangs zwischen Halbleitermodul und Kühlkörper wird vorgeschlagen, dass der Kühlkörper mittels eines additiven Fertigungsverfahrens auf eine Bodenplatte des Halbleitermoduls aufgetragen wird, wobei der Kühlkörper durch Auftragen eines Materials gebildet wird, das Metall und/oder einen Keramikanteil aufweist. Weiter betrifft die Erfindung ein Halbleitermodul mit einem Kühlkörper, wobei der Kühlkörper mittels eines solchen Verfahrens an der Bodenplatte des Halbleitermoduls angeordnet ist.

## Patentansprüche

1. Verfahren zur Herstellung eines Halbleitermoduls (1) mit einem Kühlkörper (2), wobei der Kühlkörper (2) mittels eines additiven Fertigungsverfahrens auf eine Bodenplatte (11) des Halbleitermoduls (1) aufgetragen wird, wobei der Kühlkörper (2) durch Auftragen eines Materials gebildet wird, das Metall und/oder einen Keramikanteil aufweist.

2. Verfahren nach Anspruch 1, wobei der Kühlkörper (2) mittels eines 3D-Druckers auf die Bodenplatte (11) aufgetragen wird.

3. Verfahren nach einem der Ansprüche 1 oder 2, wobei beim Auftragen des Materials innerhalb des Kühlkörpers (2) mindestens ein Hohlraum (22) vorgesehen wird, der mit einem Fluid durchströmbar ist.

4. Verfahren nach einem der Ansprüche 1 bis 3, wobei das aufgetragene Material in Form von Kühlrippen aufgetragen wird.

5. Verfahren nach Anspruch 4, wobei zwischen zumindest zwei der Kühlrippen Material eingebracht wird, das die zumindest zwei der Kühlrippen durch einen Steg (21) miteinander verbindet.

6. Halbleitermodul (1) mit einem Kühlkörper (2), wobei der Kühlkörper (2) mittels eines Verfahrens nach einem der Ansprüche 1 bis 5 an der Bodenplatte (11) des Halbleitermoduls (1) angeordnet ist.
